# EUROPÄISCHE PATENTANMELDUNG

(11) **EP 4 059 657 A2**
(43) Veröffentlichungstag der Anmeldung: **21.09.2022**
(21) Anmeldenummer: 22160676.7
(22) Anmeldetag: 08.03.2022
(51) Int. Cl.: B23K 37/02, B23K 37/04, B23P 19/04, B23P 19/06, B23P 19/10, G01R 1/02, G01R 31/36

(54) **FÜGE- UND/ODER PRÜFEINHEIT**

(30) Priorität: 18.03.2021 DE 102021106597
(71) Anmelder: Liebherr-Verzahntechnik GmbH, 87437 Kempten (DE)
(72) Erfinder: Hößle, Florian, 87527 Sonthofen (DE); Zollitsch, Markus, 87490 Haldenwang (DE); Pollmann, Jan, 87439 Kempten (DE)
(74) Vertreter: Behr, Wolfgang

(57) **Zusammenfassung**

Die vorliegende Erfindung umfasst eine Füge- und/oder Prüfeinheit zum Fügen und/oder Prüfen eines Bauteils mit einer Basis und einer Mehrzahl von Füge- und/oder Prüfelementen, wobei die Füge- und/oder Prüfelemente so an der Basis angeordnet sind, dass sie jeweils an einem Füge- und/oder Prüfpunkt des Bauteils eine Verbindung herstellen und/oder eine Prüfung vornehmen. Dabei ist vorgesehen, dass die Füge- und/oder Prüfelemente über eine Verstellanordnung, welche eine Verstellung des Abstands der Füge- und/oder Prüfelemente voneinander erlaubt, an der Basis angeordnet sind, wobei die Verstellanordnung bevorzugt eine erste und eine zweite Verstellachse umfasst, über welche der Abstand der Füge- und/oder Prüfelemente voneinander in einer ersten und einer zweiten Richtung verstellbar ist.

## Beschreibung

Die vorliegende Erfindung betrifft eine Füge- und/oder Prüfeinheit zum Fügen und/oder Prüfen eines Bauteils mit einer Basis und einer Mehrzahl von Füge- und/oder Prüfelementen, wobei die Füge- und/oder Prüfelemente so an der Basis angeordnet sind, dass sie jeweils an einem Füge- und/oder Prüfpunkt des Bauteils eine Verbindung herstellen und/oder eine Prüfung vornehmen.

Solche Füge- und/oder Prüfeinheiten können beispielsweise an einem Roboterarm angeordnet werden, um Bauteile zu montieren und/oder zu prüfen. Bei den Füge- und/oder Prüfelementen kann es sich beispielsweise als Schrauber oder um Messgeräte zur Prüfung elektrischer Eigenschaften des Bauteils handeln. Insbesondere kommt die Füge- und/oder Prüfeinheit zum Fügen und/oder Prüfen von Batterieelementen wie bspw. Batteriemodulen oder Gehäusebestandteilen von Batteriepacks oder Batteriepacks zum Einsatz, insbesondere für elektrisch oder hybrid-elektrisch angetriebene Fahrzeuge.

Weiterhin betrifft die vorliegende Erfindung eine Füge- und/oder Prüfeinheit, welche neben einem oder mehreren Füge- und/oder Prüfelementen weiterhin einen Greifer umfasst.

Bekannte Füge- und/oder Prüfeinheiten sind üblicherweise spezifisch zum Fügen und/oder Prüfen eines einzigen Bauteils konstruiert, und insbesondere im Hinblick auf die geometrische Anordnung der Füge- und/oder Prüfelemente an die Position der Füge- und/oder Prüfpunkte des Bauteils angepasst.

Aufgabe der vorliegenden Erfindung ist es, eine verbesserte Füge- und/oder Prüfeinheit zur Verfügung zu stellen.

Diese Aufgabe wird durch Füge- und/oder Prüfeinheiten gemäß den unabhängigen Ansprüchen 1 und 5 gelöst. Bevorzugte Ausgestaltungen der vorliegenden Erfindung sind Gegenstand der Unteransprüche.

In einem ersten Aspekt umfasst die vorliegende Erfindung eine Füge- und/oder Prüfeinheit zum Fügen und/oder Prüfen eines Bauteils mit einer Basis und einer Mehrzahl von Füge- und/oder Prüfelementen, wobei die Füge- und/oder Prüfelemente so an der Basis angeordnet sind, dass sie jeweils an einem Füge- und/oder Prüfpunkt des Bauteils eine Verbindung herstellen und/oder eine Prüfung vornehmen. Dabei ist vorgesehen, dass die Füge- und/oder Prüfelemente über eine Verstellanordnung, welche eine Verstellung des Abstands der Füge- und/oder Prüfelemente voneinander erlaubt, an der Basis angeordnet sind.

Die vorliegende Erfindung erlaubt hierdurch die flexible Anpassung der Füge- und/oder Prüfeinheit an unterschiedliche Bauteile und insbesondere an Bauteile mit einer unterschiedlichen geometrischen Anordnung der Füge- und/oder Prüfpunkte des Bauteils. Hierdurch ist das Fügen und/oder Prüfen solcher unterschiedlichen Bauteile mit der gleichen Füge- und/oder Prüfeinheit möglich.

Die Verstellung des Abstand der Füge- und/oder Prüfelemente zueinander gemäß dem ersten Aspekt kann insbesondere durch eine der folgenden Varianten verwirklicht werden:
In einer ersten Variante der vorliegenden Erfindung kann die Füge- und/oder Prüfeinheit eine Mehrzahl von Fügeelementen umfassen, wobei die Verstellanordnung eine Verstellung des Abstands der Fügeelemente voneinander erlaubt.

In einer zweiten Variante der vorliegenden Erfindung kann die Füge- und/oder Prüfeinheit eine Mehrzahl von Prüfelementen umfassen, wobei die Verstellanordnung eine Verstellung des Abstands der Prüfelemente voneinander erlaubt.

In einer dritten Variante der vorliegenden Erfindung kann die Füge- und/oder Prüfeinheit mindestens ein Fügeelement und mindestens ein Prüfelement umfassen, wobei die Verstellanordnung eine Verstellung des Abstands des Fügeelements von dem Prüfelement erlaubt.

Die drei Varianten können auch untereinander kombiniert werden.

In einer möglichen Ausgestaltung umfasst die Verstellanordnung eine erste und eine zweite Verstellachse, über welche der Abstand der Füge- und/oder Prüfelemente voneinander in einer ersten und einer zweiten Richtung verstellbar ist.

Die erste Verstellachse kann eine Verstellung gemäß einer der drei oben genannten Varianten oder einer Kombination dieser drei Varianten bewirken.

Die zweite Verstellachse kann eine Verstellung gemäß einer der drei oben genannten Varianten oder einer Kombination dieser drei Varianten bewirken.

Die erste und die zweite Verstellachse können entweder eine Verstellung gemäß der gleichen Variante und/oder Kombination von Varianten bewirken, oder eine Verstellung gemäß unterschiedlichen Varianten und/oder Kombinationen von Varianten bewirken.

In einer möglichen Ausgestaltung steht eine Achsrichtung der ersten Verstellachse senkrecht auf einer Achsrichtung der zweiten Verstellachse.

In einer möglichen Ausgestaltung ist durch die erste und zweite Verstellachse der Abstand der Füge- und/oder Prüfelemente und/oder Füge- und/oder Prüfpunkte in einer Ebene verstellbar. Insbesondere kann diese Ebene senkrecht auf einer Füge- und/oder Prüfrichtung stehen. Bei der Füge- und/oder Prüfrichtung kann es sich um eine Richtung handeln, in welcher das Füge- und/oder Prüfelement an den Füge- und/oder Prüfpunkt bewegt wird.

In einer möglichen Ausgestaltung umfasst die Füge- und/oder Prüfeinheit mindestens einen Greifer zum Greifen des Bauteils. Insbesondere kann die Füge- und/oder Prüfeinheit in diesem Fall zum Montieren und/oder zum Handling des Bauteils mittels des Greifers eingesetzt werden, wobei das Bauteils durch das Füge- und/oder Prüfelement gefügt und/oder geprüft wird.

In einer möglichen Ausgestaltung erlaubt der Greifer ein Halten des Bauteils in einer Soll-Position, während das Bauteil durch die Füge- und/oder Prüfelemente gefügt und/oder geprüft wird. Insbesondere kann der Greifer das Bauteil in einer Soll-Position halten, insbesondere in einer Soll-Montageposition.

Insbesondere ist eine Steuerung vorgesehen, durch welche der Greifer im Rahmen eines automatischen Montage- und/oder Handhabungsprozesses das Bauteil greift und das Bauteil hält, während das Bauteil durch die Füge- und/oder Prüfelemente gefügt und/oder geprüft wird.

In einer möglichen Ausgestaltung ist die Steuerung so ausgestaltet, dass das Fügen erfolgt, während der Greifer das Bauteil in einer Soll-Montageposition hält.

In einer möglichen Ausgestaltung ist die Steuerung so ausgestaltet, dass das Prüfen erfolgt, während der Greifer das Bauteil in eine Soll-Montageposition bewegt und/oder in der Soll-Montageposition hält.

In einer möglichen Ausgestaltung umfasst der Greifer mindestens zwei Greifaktoren, über welche Greifelemente zum Greifen des Bauteils betätigbar sind, wobei die Greifaktoren über die Verstellanordnung an der Basis angeordnet sind, so dass der Abstand der Greifaktoren zueinander verstellbar ist.

Die vorliegende Erfindung umfasst in einem zweiten Aspekt eine Füge- und/oder Prüfeinheit zum Fügen und/oder Prüfen eines Bauteils mit einer Basis, einem Greifer und einem oder mehreren Füge- und/oder Prüfelementen, wobei der Greifer mindestens zwei Greifaktoren umfasst, über welche Greifelemente zum Greifen des Bauteils betätigbar sind, und wobei das oder die Füge- und/oder Prüfelemente so an der Basis angeordnet sind, dass sie jeweils an einem Füge- und/oder Prüfpunkt des Bauteils eine Verbindung herstellen und/oder eine Prüfung vornehmen. Gemäß dem zweiten Aspekt ist vorgesehen, dass die Greifaktoren und das oder die Füge- und/oder Prüfelemente über eine Verstellanordnung an der Basis angeordnet sind, über welche der Abstand der Greifaktoren und/oder des oder der Füge- und/oder Prüfelemente zueinander verstellbar ist.

Die vorliegende Erfindung erlaubt hierdurch die flexible Anpassung der Füge- und/oder Prüfeinheit an unterschiedliche Bauteile und insbesondere an Bauteile mit einer unterschiedlichen geometrischen Anordnung der Greif-, Füge- und/oder Prüfpunkte des Bauteils. Hierdurch ist das Greifen und das Fügen und/oder Prüfen solcher unterschiedlichen Bauteile mit der gleichen Füge- und/oder Prüfeinheit möglich.

Die Verstellung des Abstand der Greifaktoren und/oder des oder der Füge- und/oder Prüfelemente zueinander gemäß dem zweiten Aspekt kann insbesondere durch eine der folgenden Varianten verwirklicht werden:
In einer ersten Variante der vorliegenden Erfindung erlaubt die Verstellanordnung eine Verstellung des Abstands der Greifaktoren voneinander.

In einer zweiten Variante der vorliegenden Erfindung erlaubt die Verstellanordnung eine Verstellung des Abstands mindestens eines Greifaktors von mindestens einem Füge- und/oder Prüfelement.

In einer dritten Variante der vorliegenden Erfindung erlaubt die Verstellanordnung eine Verstellung des Abstands der Füge- und/oder Prüfelemente voneinander. Hierbei umfasst die vorliegende Erfindung gemäß dem zweiten Aspekt die gemäß dem ersten Aspekt beschriebenen Varianten und deren Kombinationen als Untervarianten.

Die drei Varianten des zweiten Aspektes können auch untereinander kombiniert werden.

In einer möglichen Ausgestaltung umfasst sind die Greifaktoren über mindestens eine erste Verstellachse zueinander in mindestens einer ersten Richtung verstellbar.

In einer möglichen Ausgestaltung umfasst sind das oder die Füge- und/oder Prüfelemente über mindestens eine zweite Verstellachse zu den Greifaktoren oder zueinander in mindestens eine zweite Richtung verstellbar.

Die vorliegende Erfindung umfasst unabhängig voneinander Füge- und/oder Prüfeinheiten gemäß dem ersten und dem zweiten Aspekt.

Weiterhin umfasst die vorliegende Erfindung jedoch auch Füge- und/oder Prüfeinheiten, bei welchen die im Hinblick auf den ersten und den zweiten Aspekt beschriebenen Merkmale in Kombination verwirklicht sind.

Mögliche Ausgestaltungen einer Füge- und/oder Prüfeinheit gemäß dem ersten und/oder dem zweiten Aspekt sind im folgenden dargestellt:
In einer möglichen Ausgestaltung handelt es sich bei dem Greifer um einen mechanischen Greifer, wobei die Greifaktoren die Greifelemente entlang einer ersten Richtung bewegen, um das Bauteil zu greifen.

Insbesondere kann hierbei der Abstand zwischen den Greifaktoren durch die Verstellanordnung in der ersten Richtung verstellbar sein, um den Greifer an unterschiedlich große Bauteile anzupassen.

Bei dem Greifer kann es sich jedoch auch um einen pneumatischen Greifer und/oder um einen Magnetgreifer handeln.

In einer möglichen Ausgestaltung sind die Greifaktoren und das oder die Füge- und/oder Prüfelemente über mindestens eine erste Verstellachse gemeinsam verstellbar.

In einer möglichen Ausgestaltung sind über mindestens eine zweite Verstellachse nur die Füge- und/oder Prüfelemente verstellbar.

In einer möglichen Ausgestaltung ist ein erster Greifaktor zusammen mit einem ersten Füge- und/oder Prüfelement oder einer Gruppe von ersten Füge- und/oder Prüfelementen an einem verstellbaren Element der ersten Verstellachse, insbesondere einem Schlitten, angeordnet.

In einer möglichen Ausgestaltung ist an dem verstellbaren Element eine zweite Verstellachse angeordnet ist, über welche das oder die ersten Füge- und/oder Prüfelemente zueinander und/oder zum Greifaktor verstellbar sind.

In einer möglichen Ausgestaltung ist mindestens eine Verstellachse so ausgestaltet, dass sie eine symmetrische Verstellung von mindestens zwei Füge- und/oder Prüfelementen und/oder Greifaktoren relativ zur Basis vornimmt.

In einer möglichen Ausgestaltung sind die erste und die zweite Verstellachse so ausgestaltet, dass sie jeweils eine symmetrische Verstellung von mindestens zwei Füge- und/oder Prüfelementen und/oder Greifaktoren relativ zur Basis vornehmen.

In einer möglichen Ausgestaltung umfasst eine erste Verstellachse zwei erste Schlitten, welche über ein erstes Antriebselement entlang einer Linearführung relativ zur Basis verfahrbar sind, wobei es sich bei dem Antriebselement bevorzugt um eine Zahnstange und/oder einen Riemenantrieb handelt.

In einer möglichen Ausgestaltung ist an jedem der beiden ersten Schlitten eine zweite Verstellachse angeordnet, wobei bevorzugt die zweiten Verstellachsen jeweils einen oder zwei zweite Schlitten umfassen, welcher oder welche jeweils über ein zweites Antriebselement entlang einer am ersten Schlitten angeordneten Linearführung verfahrbar ist oder sind.

Bei den zweiten Antriebselementen kann es sich um eine Zahnstange und/oder einen Riemenantrieb handeln.

In einer möglichen Ausgestaltung sind die beiden zweiten Verstellachsen, welche an den Schlitten der ersten Verstellachse angeordnet sind, über ein drittes Antriebselement gemeinsam antreibbar. Insbesondere sind die zweiten Antriebselemente über ein drittes Antriebselement gemeinsam antreibbar.

In einer möglichen Ausgestaltung umfasst die Füge- und/oder Prüfeinheit eine oder mehrere Fixiereinheiten zur Fixierung der ersten und/oder zweiten Verstellachse, wobei es sich insbesondere um eine oder mehrere Klemm- und/oder Verriegelungseinheiten handelt.

In einer möglichen Ausgestaltung umfasst die Füge- und/oder Prüfeinheit ein oder mehrere Anschlagelemente, welche eine Oberseite des Bauteils kontaktieren, um dieses in Position zu drücken.

In einer möglichen Ausgestaltung umfasst die Füge- und/oder Prüfeinheit eine Kraftmesseinheit zum Messen einer Andrückkraft.

In einer möglichen Ausgestaltung ist die Kraftmesseinheit zwischen der Basis und einem Montagebereich zur Montage der Füge- und/oder Prüfeinheit an einer Handling-Anordnung, insbesondere einem Roboterarm, angeordnet.

In einer möglichen Ausgestaltung umfasst die Basis einen Rahmen, dessen Hauptebene sich parallel zur ersten Richtung der ersten Verstellachse erstreckt, insbesondere parallel zu einer ersten Richtung, in welcher der Abstand zweier Greifaktoren verstellbar ist.

In einer möglichen Ausgestaltung sind das oder die Füge- und/oder Prüfelemente neben dem Rahmen an der zweiten Verstellachse angeordnet.

In einer möglichen Ausgestaltung erstreckt sich die zweite Verstellachse und/oder ein Schlitten der ersten Verstellachse, an welcher eine zweite Verstellachse angeordnet ist, durch eine Aussparung des Rahmens in einer Richtung quer zur Hauptebene des Rahmens.

In einer möglichen Ausgestaltung handelt es sich bei dem einen oder mehreren Füge- und/oder Prüfelementen um Fügegeräte und/oder um Elemente eines Prüfgerätes und/oder um Prüfgeräte. Handelt es sich um Elemente eines Prüfgerätes, kann das Prüfgerät insgesamt an der Füge- und/oder Prüfeinheit angeordnet sein, oder die Elemente stehen mit anderen Teilen des Prüfgerätes, welche nicht an der Füge- und/oder Prüfeinheit angeordnet sind, in Kommunikationsverbindung.

Insbesondere handelt es sich bei dem einen oder mehreren Füge- und/oder Prüfelementen um eines oder mehrere der folgenden Geräte oder Elemente:
- Schrauber oder Nietgeräte, insbesondere mit automatischer Zuführung;
- Schweißgeräte, insbesondere zum Punktschweißen;
- Betätigungsaktoren zum Betätigen eines Befestigungselementes des Bauteils.
- Elemente eines Prüfgeräts zum Prüfen elektrischer Eigenschaften des Bauteils, insbesondere eines Spannungs-, Strom- und/oder Widerstandsprüfgerätes, insbesondere um Kontaktelemente eines Prüfergerätes zum Prüfen elektrischer Eigenschaften des Bauteils.

In einer möglichen Ausgestaltung umfasst die Füge- und/oder Prüfeinheit zwei oder mehr Fügeelemente, insbesondere zwei oder mehr Fügeelemente, welche die gleiche Art der Fügung vornehmen, insbesondere zwei oder mehr identische Fügeelemente.

In einer möglichen Ausgestaltung umfasst die Füge- und/oder Prüfeinheit zwei oder mehr Prüfelemente, insbesondere zwei oder mehr Kontaktelemente eines Prüfergerätes zum Prüfen elektrischer Eigenschaften des Bauteils.

In einer möglichen Ausgestaltung umfasst die Füge- und/oder mindestens ein Prüfelement und mindestens ein Fügeelement. Weiterhin kann die Füge- und/oder mindestens zwei Prüfelemente und/oder mindestens zwei Fügeelemente umfassen.

Insbesondere kann die Füge- und/oder Prüfeinheit zum automatisierten Montieren, Fügen und/oder Prüfen der Bauteile eingesetzt werden. Eine Steuerung für die Füge- und/oder Prüfeinheit ist hierfür bevorzugt ausgestaltet, um die Füge- und/oder Prüfeinheit zur automatisierten Durchführung dieser Vorgänge anzusteuern.

Bevorzugt ist die Steuerung programmiert, um die Füge- und/oder Prüfeinheit automatisiert so anzusteuern, wie dies oben oder im folgenden im Hinblick auf die Einsatz- und/oder Betriebsmöglichkeiten und/oder den Einsatz und/oder Betrieb der Handling-Anordnung und/oder der Füge- und/oder Prüfeinheit beschrieben ist.

Die vorliegende Erfindung umfasst weiterhin eine Handhabungsstation mit einer Handling-Anordnung, insbesondere einem Roboter, und einer Füge- und/oder Prüfeinheit, wie sie oben beschrieben wurde, wobei die Füge- und/oder Prüfeinheit an der Handling-Anordnung angeordnet und durch diese bewegt wird.

Insbesondere kann es sich um eine Handhabungsstation zur automatisierten Handhabung der Bauteile, insbesondere zum automatisierten Montieren, Fügen und/oder Prüfen der Bauteile, handeln. Die Handhabungsstation umfasst bevorzugt eine Steuerung für die Handling-Anordnung und die Füge- und/oder Prüfeinheit, welche ausgestaltet ist, um die Handling-Anordnung und die Füge- und/oder Prüfeinheit zur automatisierten Durchführung dieser Vorgänge anzusteuern.

Bevorzugt ist die Steuerung programmiert, um die Handling-Anordnung und die Füge- und/oder Prüfeinheit automatisiert so anzusteuern, wie dies oben oder im folgenden im Hinblick auf die Einsatz- und/oder Betriebsmöglichkeiten und/oder den Einsatz und/oder Betrieb der Handling-Anordnung und/oder der Füge- und/oder Prüfeinheit beschrieben ist.

Die Steuerung der Handhabungsstation und/oder für die Füge- und/oder Prüfeinheit umfasst bevorzugt einen Mikroprozessor und einen nicht-flüchtigen Speicher, auf welchem ein Programmcode abgespeichert ist, welcher auf dem Mikroprozessor abläuft und hierbei die Handling-Anordnung und/oder die Füge- und/oder Prüfeinheit automatisiert ansteuert. Der Mikroprozessor steht bevorzugt mit Sensoren und/oder Aktoren der Handling-Anordnung und der Füge- und/oder Prüfeinheit in Verbindung und erhält von diesen Signale und/oder steuert diese an.

Insbesondere kann die Handhabungsstation Teil einer Produktionsstraße sein, insbesondere einer automatisierten Produktionsstraße.

In einer möglichen Ausgestaltung ist vorgesehen, dass eine Steuerung der Handling-Anordnung eine Andrückkraft überwacht und auf einen Soll-Wert regelt.

In einer möglichen Ausgestaltung ist vorgesehen, dass eine Steuerung der Handling-Anordnung den Greifer und die Füge- und/oder Prüfeinheit so ansteuert, dass ein Fügen und/oder Prüfen des Bauteils erfolgt, während dieses durch den Greifer gehalten wird.

In einer möglichen Ausgestaltung dient die Füge- und/oder Prüfeinheit oder die Handhabungsstation zur Montage und/oder Prüfung von Batterieelementen, insbesondere zur Montage von Batteriemodulen und/oder Gehäusebauteilen an Batteriepacks und/oder von Batteriepacks an einem Fahrzeug.

Die vorliegende Erfindung umfasst weiterhin ein Verfahren zum Betrieb einer Füge- und/oder Prüfeinheit oder einer Handhabungsstation, wie sie oben beschrieben wurde.

Das Verfahren kann insbesondere einen Schritt des Fügens und/oder Prüfens des Bauteils durch eine oder mehrere Füge- und/oder Prüfelemente der Füge- und/oder Prüfeinheit umfassen.

Das Verfahren kann insbesondere einen Schritt des Greifens des Bauteils durch einen Greifer der Füge- und/oder Prüfeinheit umfassen.

Das Verfahren kann insbesondere die Montage von Batterieelementen, insbesondere zur Montage von Batteriemodulen und/oder Gehäusebauteilen an Batteriepacks und/oder von Batteriepacks an einem Fahrzeug, umfassen.

In einer möglichen Ausgestaltung wird die Andrückkraft überwacht und auf einen Soll-Wert geregelt.

In einer möglichen Ausgestaltung erfolgt ein Fügen und/oder Prüfen des Bauteils, während dieses durch den Greifer in einer Soll-Position gehalten wird.

In einer möglichen Ausgestaltung erfolgt das Verfahren so, wie dies oben und im folgenden im Hinblick auf die auf die Einsatz- und/oder Betriebsmöglichkeiten und/oder den Einsatz und/oder Betrieb der Handling-Anordnung und/oder der Füge- und/oder Prüfeinheit beschrieben ist.

Die vorliegende Erfindung wird nun anhand von Zeichnungen und Ausführungsbeispielen näher beschrieben. Dabei zeigen:
- Fig. 1:: ein erstes Ausführungsbeispiel einer erfindungsgemäßen Füge- und/oder Prüfeinheit in einer perspektivischen Darstellung,
- Fig. 2:: das in Fig. 1 dargestellte Ausführungsbeispiel in einer Seitenansicht,
- Fig. 3:: ein zweites Ausführungsbeispiel einer erfindungsgemäßen Füge- und/oder Prüfeinheit, wobei der besseren Übersicht halber die Füge- und/oder Prüfelemente nicht dargestellt sind,
- Fig. 4:: ein drittes Ausführungsbeispiel einer erfindungsgemäßen Füge- und/oder Prüfeinheit in einer perspektivischen Darstellung und
- Fig. 5:: das in Fig. 4 dargestellte Ausführungsbeispiel in einer Seitenansicht.

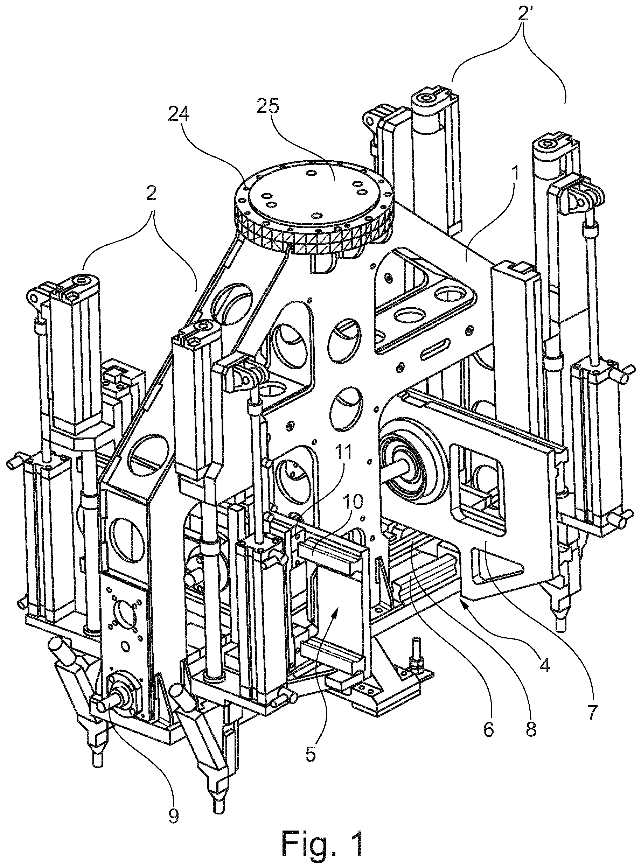

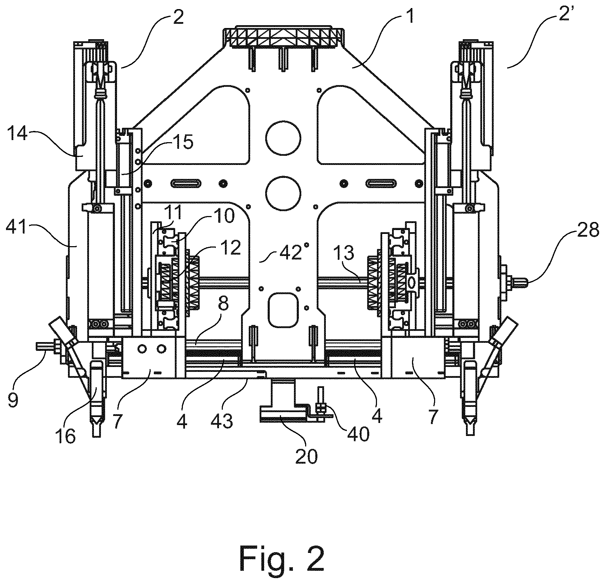

Fig. 1 und 2 zeigen ein erstes Ausführungsbeispiel einer erfindungsgemäßen Füge- und/oder Prüfeinheit mit einer Basis 1, an welcher eine Mehrzahl von Füge- und/oder Prüfelemente 2 und 2' angeordnet sind.

Wie in Fig. 1 und 2 ersichtlich handelt es sich im Ausführungsbeispiel bei den Füge- und/oder Prüfelementen um Fügegeräte, insbesondere um Schrauber.

Diese weisen im Ausführungsbeispiel um einen Fügeantrieb auf, insbesondere einen Schraubantrieb 14, welcher eine Schrauberwelle antreibt. Weiterhin ist ein Linearantrieb 15, insbesondere in Form eines Pneumatikzylinders, vorgesehen, über welchen der Schrauber in Fügerichtung verfahrbar ist. Weiterhin ist eine automatische Fixierelementzuführung 16 vorgesehen, hier zur Zuführung von Schrauben.

Es handelt sich bei einem Schrauber jedoch lediglich um ein Beispiel für ein erfindungsgemäß einsetzbares Füge- und/oder Prüfelement.

Beispielsweise könnten anstelle von Schraubern auch andere Fügegeräte eingesetzt werden, bspw. Niet-Geräte. Ebenso ist der Einsatz von Schweißgeräten als Füge- und/oder Prüfelemente denkbar, insbesondere zum Punktschweißen. Weiterhin kann es sich bei den Füge- und/oder Prüfelementen um Betätigungsaktoren zum Betätigen eines Befestigungselementes des Bauteils handeln. Beispielsweise kann über einen solchen Betätigungsaktor ein bereits am Bauteil vorhandenes Fixierelement eingedrückt werden.

Weiterhin kann anstelle eines oder mehrerer der Fügegeräte auch ein Prüfelement vorgesehen sein.

Beispielsweise kann es sich bei dem Prüfelement um ein Kontaktelement eines Prüfgerätes zum Messen elektrischer Eigenschaften des Bauteils handeln. Insbesondere ist das Kontaktelement ausgestaltet, um einen elektrischen Anschluss des Bauteils zu kontaktieren.

Insbesondere können mindestens zwei Kontaktelemente vorgesehen sein, um elektrische Anschlüsse des Bauteils zu kontaktieren.

Bei den Prüfelementen kann es sich jedoch auch jeweils um eigenständige Prüfgeräte.

Bei den Prüfelementen kann es sich weiterhin Prüfgeräte und/oder Bestandteile von Prüfgeräten zum Prüfen anderer Eigenschaften des Bauteils handeln, bspw. zum Prüfen optischer oder mechanischer Eigenschaften des Bauteils.

Die Füge- und/oder Prüfelemente 2 und 2' sind über eine Verstellanordnung an der Basis 1 angeordnet, über welche der Abstand der Füge- und/oder Prüfelemente voneinander verstellbar ist.

Im Ausführungsbeispiel ist dabei eine erste Verstellachse 4 vorgesehen, über welche der Abstand der Füge- und/oder Prüfelemente 2 von den Füge- und/oder Prüfelementen 2' verändert werden kann. Weiterhin ist eine zweite Verstellachse 5 vorgesehen, über welche der Abstand der beiden Füge- und/oder Prüfelementen 2 voneinander sowie der Abstand der Füge- und/oder Prüfelemente 2' voneinander verstellt werden kann.

Die beiden Verstellachsen 4 und 5 sind so an der Basis 1 angeordnet, dass der Abstand der Füge- und/oder Prüfelemente 2 und 2' und damit der Füge- und/oder Prüfpunkte, an welchen diese das Bauteil fügen oder prüfen können, in einer Ebene verstellbar ist.

Diese Ebene und damit die Bewegungsrichtungen der ersten und zweiten Verstellachse 4 und 5 stehen im Ausführungsbeispiel senkrecht auf der Füge- und/oder Prüfrichtung, welche vorliegend durch die Ausrichtung der Schrauberachse beziehungsweise die Ausrichtung der Linearachse 15 zum Bewegen der Füge- und/oder Prüfelemente in Füge- und/oder Prüfrichtung definiert ist.

Im Ausführungsbeispiel stehen die erste und die zweite Verstellachse senkrecht aufeinander, und dienen damit zur Längen- und Breitenverstellung der Füge- und/oder Prüfelemente.

Im Ausführungsbeispiel handelt es sich bei der Basis 1 um eine Schweißkonstruktion, an welcher die Verstellanordnung für die Füge- und/oder Prüfelemente angeordnet ist.

Die Basis 1 umfasst einen Montageabschnitt 25, mit welchem sie an einem Endglied einer Handling-Anordnung, beispielsweise am Endglied eines Roboterarms montiert werden kann.

Im Ausführungsbeispiel ist weiterhin eine Kraftmesseinheit 24 vorgesehen, welche zwischen der Basis 1 und dem Montageabschnitt 25 vorgesehen ist. Über diese Kraftmesseinheit kann insbesondere eine Andrückkraft, welche über die Füge- und/oder Prüfeinheit auf ein Bauteil ausgeübt wird, gemessen werden.

Die Füge- und/oder Prüfeinheit kann weiterhin Anschlagelemente 20 umfassen, mit welchen sie eine Oberseite des Bauteils kontaktiert, um dieses in eine vorgegebene Position zu drücken. Alternativ oder zusätzlich können die Anschlagelemente auch zur korrekten Positionierung der Füge- und/oder Prüfeinheit am Bauteil eingesetzt werden.

Weiterhin ist ein Kontaktsensor 40 vorgesehen, mit welchem der Kontakt zwischen der Füge- und/oder Prüfeinheit und dem Bauteil überwacht wird. Im Ausführungsbeispiel ist dieser am Anschlagelement 20 angeordnet.

Die Verstellachsen 4 und 5 sind im Ausführungsbeispiel jeweils als Linearachsen ausgeführt.

Die erste Verstellachse 4 umfasst Linearführungen 6, an welchen die Schlitten 7 linearverschieblich angeordnet sind. An den Schlitten 7 der ersten Linearachse sind wiederum Führungen 10 der zweiten Verstellachsen angeordnet. An den Führungen 10 der zweiten Verstellachsen sind Schlitten 11 linearverschieblich angeordnet.

Im Ausführungsbeispiel sind die Füge- und/oder Prüfelemente 2, 2' jeweils an den Schlitten 11 der zweiten Verstellachsen angeordnet.

Im Ausführungsbeispiel sind die erste und die zweite Verstellachse jeweils so ausgestaltet, dass zwei an der Führung verschiebliche Schlitten vorgesehen sind. In alternativen Ausführungsbeispielen wäre es jedoch ebenfalls denkbar, die erste und/oder die zweite Verstellachse jeweils nur mit einem verstellbaren Schlitten auszugestalten.

Im Ausführungsbeispiel erlauben die erste und die zweite Verstellachse jeweils eine synchrone Verstellung der an ihr angeordneten Füge- und/oder Prüfeinheiten in die erste beziehungsweise die zweite Verstellrichtung. Auch hier sind jedoch alternative Ausgestaltungen denkbar, bei welchen keine synchrone Verstellung erfolgt.

Im Ausführungsbeispiel erfolgt die Verstellung der Schlitten 7 an der ersten Verstellachse über eine gegenläufige Trapezspindel 8, welche an der Basis gelagert ist und an den Schlitten 7 angreift. Durch Drehen der Trapezspindel 8 kann daher der Abstand der beiden Schlitten 7 zueinander verstellt werden.

Die Trapezspindel 8 weist eine Antriebswelle 9 auf, an welcher beispielsweise ein mechanisch betätigbares Verstellelement wie ein Handgriff oder Drehrad, oder ein Antrieb, bspw. mit einem Motor, angreifen kann.

Die Basis 1 bildet im Ausführungsbeispiel einen Rahmen, welcher an seiner Unterseite eine Montageplatte trägt, an welcher die Linearführungen 6 der ersten Verstellachse angeordnet sind. Im Ausführungsbeispiel umfasst der Rahmen 41 eine Mittelstrebe 42, welche die Montageplatte 43 zusätzlich an einer mittleren Position stützt. Die jeweiligen Linearführungen 6 für die beiden Schlitten 7 erstrecken sich zwischen den äußeren Streben und der Mittelstrebe 42 des Rahmens 41.

Im Ausführungsbeispiel sind die Führungen 6 auf der dem Bauteil abgewandten Seite der Montageplatte 43 angeordnet. Weiterhin verlaufen die Schlitten 7 auf der dem Bauteil abgewandten Seite der Montageplatte in Aussparungen des Rahmens 41.

Die Schlitten 7 tragen jeweils Montageplatten, welche sich in Querrichtung erstrecken, und an welchen Linearführungen 10 der zweiten Verstellachse 5 angeordnet sind. An den Linearführungen 10 sind die Schlitten 11 linearverschieblich geführt.

Die beiden Schlitten 7 sind dabei im Ausführungsbeispiel symmetrisch angeordnet und aufgebaut.

Die zweiten Verstellachsen umfassen im Ausführungsbeispiel jeweils Führungsschienen 10 für zwei Schlitten 11, an welchen jeweils ein Füge- und/oder Prüfelement angeordnet ist. In alternativen Ausgestaltungen könnte jedoch an den zweiten Verstellachsen jeweils nur ein Schlitten 11 angeordnet sein. Beispielsweise wäre eine diagonale Anordnung der Schlitten 11 an den jeweiligen Linearführungen 10 der beiden Schlitten 7 denkbar.

Im Ausführungsbeispiel erstrecken sich die Führungsschienen 10 der zweiten Verstellachse jeweils aus der Hauptebene des gabelförmigen Rahmens 41 der Basis 1 heraus. Die Schlitten 11 sind seitlich neben dem Rahmen 41 angeordnet, so dass die Füge- und/oder Prüfelemente nicht durch die Aussparungen im Rahmen in ihrer Größe beschränkt sind, sondern neben diesen angeordnet sein können.

Der Schlitten 7, welcher die Linearführungen trägt, und insbesondere die Montageplatte, an welcher die Linearführungen 10 angeordnet sind, erstreckt sich jedoch durch eine Aussparung im Rahmen 41 hindurch.

Die Linearführungen 6 und 10 weisen im Ausführungsbeispiel jeweils zwei parallel zueinander verlaufende Führungselemente auf, um eine sichere Führung zu gewährleisten. Im Ausführungsbeispiel verlaufen die Führungselemente der Linearführung 6 in einer horizontalen Ebene nebeneinander, die Führungselemente der Linearführungen 10 in einer vertikalen Ebene übereinander.

Im Ausführungsbeispiel sind auch die Schlitten 11 jeweils symmetrisch zueinander verstellbar.

Weiterhin sind die Schlitten 11 der zweiten Verstellachse an beiden Schlitten 7 der ersten Verstellachse über ein gemeinsames Antriebselement, im Ausführungsbeispiel eine Drehmomentwelle 13, verstellbar.

Die Drehmomentwelle 13 treibt hierfür jeweils Antriebe 12 an, über welche die Verstellung der Schlitten 11 der zweiten Verstellachse erfolgt.

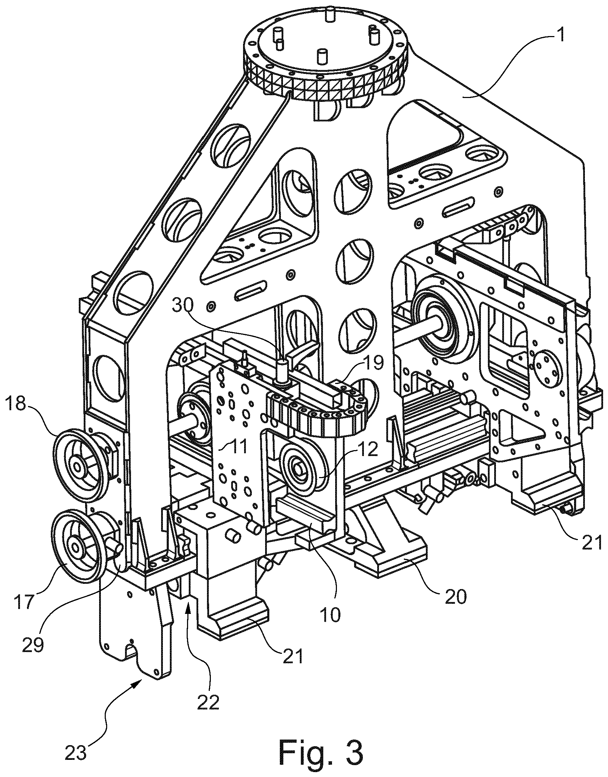

Bei den Antrieben 12 handelt es sich im Ausführungsbeispiel um Riemenantriebe. Wie deutlicher in Fig. 3 erkennbar, welche ein Ausführungsbeispiel mit dem gleichen Grundaufbau zeigt, wobei in Fig. 3 die Füge- und/oder Prüfelemente der besseren Übersichtlichkeit halber nicht dargestellt sind, sind an den Montageplatten, an welchen die zweiten Verstellachsen 5 angeordnet sind, Riemenscheiben gelagert, über welche ein Riemen 12 umläuft. Der Riemen wird über die Drehmomentwelle 13 angetrieben. An die Riemen sind jeweils die Schlitten 11 gekoppelt, so dass sie bei einer Bewegung des Riemens entlang der Linearführung 10 verstellt werden.

Die Ausgestaltung der Riemenantriebe und deren Kopplung an den Schlitten 11 ist so ausgestaltet, dass die Schlitten 11 in der zweiten Richtung bzw. Breitenrichtung symmetrisch zueinander bewegt werden.

Der Antrieb der Drehmomentwelle 13 erfolgt im Ausführungsbeispiel über die aus dem Rahmen 41 herausgeführte Antriebswelle 28. An dieser kann wiederum ein Betätigungselement zur mechanischen Betätigung oder ein Antrieb angreifen.

Bei den oben beschriebenen konstruktiven Ausgestaltungen der ersten und der zweiten Verstellachse handelt es sich lediglich um beispielhafte Ausgestaltungen, welche im Rahmen des Ausführungsbeispiels eingesetzt werden, um eine äußerst zuverlässige Verstellung zu ermöglichen. Der Einsatz alternativer Linearachsen und alternativer Antriebe zum Antrieb solcher Linearachsen ist jedoch ebenfalls denkbar.

Die erste und/oder zweite Verstellachse können jeweils über eine Fixiereinheit verfügen, über welche sie in einer durch die jeweilige Verstellachse einstellbaren Position fixiert werden können. Beispielsweise kann es sich hierbei um eine Klemm- und/oder Verriegelungseinheit handeln.

Im Ausführungsbeispiel ist eine Klemmeinheit 29 für die erste Verstellachse 4 vorgesehen. Im Ausführungsbeispiel wirkt diese auf die Trapezspindel 8. Für die zweite Verstellachse ist eine Klemmeinheit 30 vorgesehen. Im Ausführungsbeispiel fixiert diese die Schlitten 11 an der Linearführung 10.

Fig. 3 zeigt dabei eine Ausgestaltung, bei welcher die erste und die zweite Verstellachse jeweils händisch über Handgriffe 17 und 18 verstellbar ist. Dementsprechend ist auch die Fixiereinheit 29 bzw. 30 über Handhebel ausgestaltet.

In einer alternativen Ausgestaltung sind die erste und/oder die zweite Verstellachse jedoch motorisch angetrieben. Bevorzugt sind in diesem Fall auch die Fixiereinheiten motorisch angetrieben.

Bevorzugt erfolgt der motorische Antrieb so, dass eine Verstellung der Füge- und/oder Prüfeinheiten taktzeitneutral zwischen der Montage und/oder Prüfung zweier Bauteile erfolgen kann. Hierdurch kann die Füge- und/oder Prüfeinheit an jeweils unterschiedliche Bauteile angepasst werden.

Bei dem in Fig. 1 und 2 gezeigten Ausführungsbeispiel sind insgesamt vier Füge- und/oder Prüfelemente vorgesehen, welche jeweils längen- und breitenverstellbar an der Basis 1 angeordnet sind.

In alternativen Ausgestaltungen könnten jedoch auch nur zwei Füge- und/oder Prüfelemente vorgesehen sein. Insbesondere könnte dabei an jedem der beiden Schlitten 7 der ersten Verstellachse nur ein Füge- und/oder Prüfelement über jeweils eine zweite Verstellachse verschieblich angeordnet sein.

In einer solchen Ausgestaltung, wie sie in Fig. 3 gezeigt ist, sind die Füge- und/oder Prüfelemente 2, 2' beziehungsweise die Schlitten 11 für die Füge- und/oder Prüfelemente bevorzugt auf gegenüberliegenden Seiten der Hauptebene des Rahmens 41 der Basis 1 angeordnet und/oder liegen sich diagonal gegenüber, so dass über die erste Verstellachse der Abstand der Füge- und/oder Prüfelemente in die erste Richtung, und über die zweite Verstellachse der Abstand der Füge- und/oder Prüfelemente in die zweite Richtung verändert werden kann.

Die konstruktive Ausgestaltung muss bei einer solchen Ausführungsform gegenüber der im Hinblick auf Fig. 1 und 2 beschriebenen Ausgestaltung ansonsten nicht geändert werden. Vielmehr wird lediglich jeweils auf einen der beiden Schlitten 11 verzichtet. Ansonsten kann die Basis, die erste Verstellachse und/oder die zweite Verstellachse so ausgeführt sein, wie es oben bereits beschrieben wurde. Wir verweisen daher im Hinblick auf den Aufbau des Ausführungsbeispiels in Fig. 3 vollumfänglich auf die Beschreibung des Ausführungsbeispiels in Fig. 1 und 2.

Die Füge- und/oder Prüfeinheit kann entweder dazu eingesetzt werden, um ein Bauteil an einer Montagepostition zu fügen, beispielsweise zu verschrauben oder zu vernieten.

Alternativ kann die Füge- und/oder Prüfeinheit jedoch auch eingesetzt werden, um Montageelemente, welche zur weiteren Montage eines Bauteils dienen, zu montieren. Insbesondere können diese Montageelemente Fügepunkte für das Bauteil zur Verfügung stellen, über welche das Bauteil an einer Grundkonstruktion montiert wird. In diesem Fall dient die Füge- und/oder Prüfeinheit nicht zum Fügen des Bauteils selbst, sondern für einen Vormontageschritt, durch welchen die Montageelemente gefügt werden.

Die Füge- und/oder Prüfeinheit kann weiterhin dazu eingesetzt werden, um ein Bauteil zu prüfen. Hierfür werden bevorzugt Prüfelemente des der Füge- und/oder Prüfeinheit mit Prüfpunkten an Bauteils angeordnet, und insbesondere mit diesen in Kontakt gebracht.

Bei dem in Fig. 1 und 2 dargestellten Ausführungsbeispiel umfasst die Füge- und/oder Prüfeinheit keinen Greifer. Sie dient daher entweder wie oben dargestellt zur Vormontage, oder zur Montage und/oder Prüfung eines anderweitig gegriffenen oder bereits platzierten Bauteils.

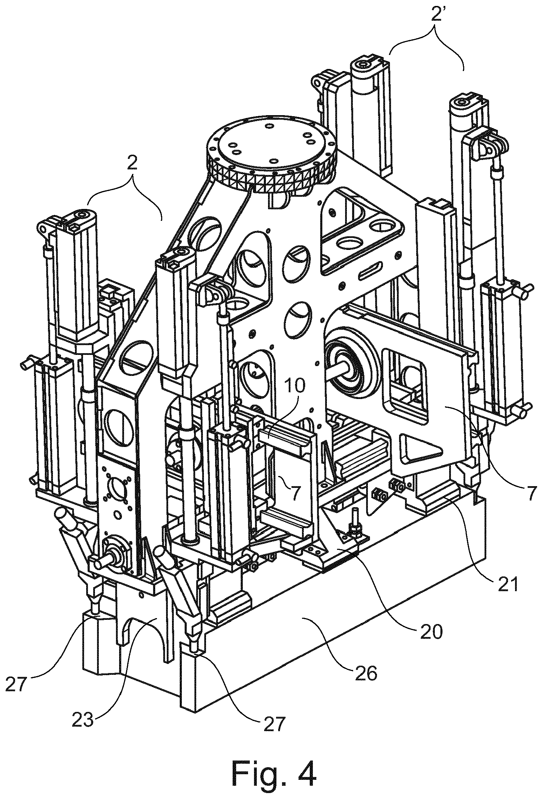

In alternativen Ausgestaltungen der vorliegenden Erfindung, wie sie nun anhand der Ausführungsbeispielen in Fig. 3 und 4 beschrieben werden, umfasst die Füge- und/oder Prüfeinheit jedoch neben einem oder mehreren Füge- und/oder Prüfelementen 2,2' weiterhin einen Greifer.

Der Greifer dient insbesondere dazu, ein Bauteil zu greifen und am Montageort zu platzieren. Der Greifer kann das Bauteil dabei halten, während es über die Füge- und/oder Prüfeinheiten gefügt und/oder geprüft wird.

In einer ersten, nicht dargestellten Variante ist der Greifer selbst nicht verstellbar, und lediglich die Füge- und/oder Prüfeinheiten sind relativ zum Greifer verstellbar. In diesem Fall könnten Bauteile gehandhabt werden, welche sich im Hinblick auf ihre Greifpunkte nicht unterscheiden, jedoch im Hinblick auf ihre Füge- und/oder Prüfpunkte.

Im Ausführungsbeispiel ist jedoch auch der Greifer verstellbar, sodass Bauteile gehandhabt werden können, welche sich sowohl im Hinblick auf ihre Greifpunkte, als auch im Hinblick auf ihre Füge- und/oder Prüfpunkte unterscheiden.

Der Greifer weist hierfür zwei Greifaktoren 22 auf, über welche jeweils ein Greifelement 23 betätigbar ist. Die Position mindestens eines der Greifaktoren 22 an der Basis ist über eine Verstellachse verstellbar, sodass der Abstand zwischen den Greifaktoren 22 und somit den Greifelementen 23 einstellbar ist.

Im Ausführungsbeispiel dient die erste Verstellachse 4 dabei sowohl zum Verstellen der Füge- und/oder Prüfelemente, als auch zum Verstellen der Greifaktoren 22. Insbesondere stellt die erste Verstellachse eine gemeinsame Längenverstellung für die Greifaktoren und die Füge- und/oder Prüfelemente dar. Die Greifaktoren 22 sind hierbei gemeinsam mit dem Füge- und/oder Prüfelementen 2,2' in der ersten Richtung in ihrem Abstand verstellbar.

Im Ausführungsbeispiel handelt es sich bei den Greifaktoren 22 um mechanische Greifaktoren, über welche die Greifelelemente 23 zum Greifen eines Bauteils aufeinander zu oder voneinander wegbewegt werden können. Bei den Greifelelementen 23 handelt es sich dabei um Greiffinger bzw. Greifbacken.

Im Ausführungsbeispiel ist die Bewegungsrichtung der Greifaktoren 22 parallel zur ersten Richtung der ersten Verstellachse ausgerichtet.

Bei den Fig. 3 und 4 dargestellten Ausführungsbeispielen dient die zweite Verstellachse lediglich zur Verstellung der Füge- und/oder Prüfelemente 2 bzw. 2'.

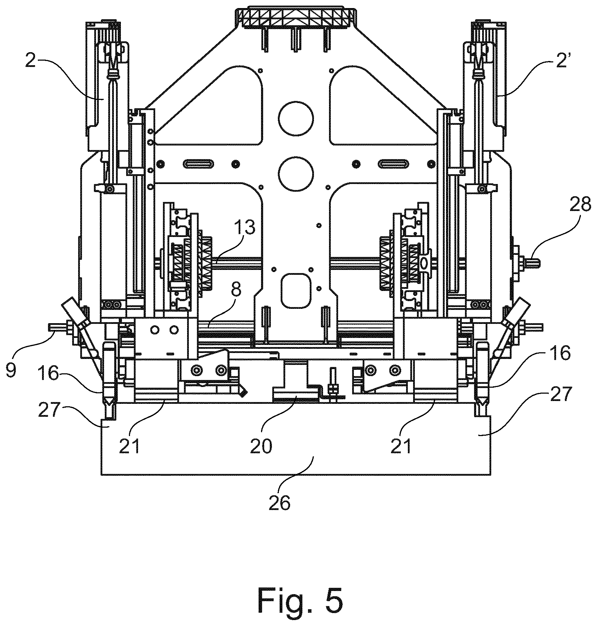

Fig. 4 und 5 zeigen dabei das Greifen eines Bauteils 26 durch den Greifer sowie das Fügen über die Füge- und/oder Prüfelemente 2 und 2'.

Das Bauteil 26 wird im Ausführungsbeispiel auf gegenüberliegenden Seiten durch die Greifelemente 23 der jeweiligen Greifaktoren 22 gegriffen. Weiterhin wird es an Füge- und/oder Prüfpunkten 27 über die Füge- und/oder Prüfelemente 2 und 2' gefügt und/oder gefügt, insbesondere an einer Montagebasis montiert.

Weiterhin sind auch hier Anschlagelemente 20 und 21 vorgesehen, welche auf der Oberseite des Bauteiles 26 aufliegen und dieses in eine vorgegebene Position und/oder mit einer definierten Kraft andrücken können.

Durch die erste und die zweite Verstellachse kann die Füge- und/oder Prüfeinheit zum Greifen und Fügen und/oder Prüfen unterschiedlicher Bauteile 26 eingesetzt werden. Insbesondere Können dabei Bauteile montiert werden, welche sich sowohl im Hinblick auf ihre Länge, als auch im Hinblick auf ihre Breite und damit den entsprechenden Abstand der Greif- und Füge- und/oder Prüfpunkte unterscheiden.

Der konstruktive Aufbau der in Fig. 3 - 5 gezeigten Ausführungsbeispiel entspricht ansonsten exakt dem konstruktiven Aufbau, welcher bereits oben im Hinblick auf Fig. 1 - 3 näher beschrieben wurde. Wir verweisen diesbezüglich daher auf die obigen Ausführungen.

Zusätzlich zu der Ausgestaltung gemäß den Fig. 1 - 3 sind hier lediglich die Greifaktoren 22 an den Schlitten 7 der ersten Verstellachse angeordnet.

Weiterhin sind zusätzlich weitere Anschlagelemente 21 vorgesehen, welche ebenfalls an den Schlitten 7 der ersten Verstellachse angeordnet sind und daher ebenfalls über die erste Verstellachse verstellbar sind.

Bei dem Ausführungsbeispiel in Fig. 3 sind dabei, wie bereits oben dargestellt, zwei diagonal angeordnete Füge- und/oder Prüfelemente vorgesehen. In alternativen Ausführungsbeispielen wäre auch denkbar, lediglich an einem der Schlitten 7 ein Füge- und/oder Prüfelement verstellbar anzuordnen.

Bei dem in Fig. 4 und 5 dargestellten Ausführungsbeispiel sind dagegen wie bei dem Ausführungsbeispiel in Fig. 1 und 2 insgesamt 4 Füge- und/oder Prüfelemente vorgesehen. Das Ausführungsbeispiel in Fig. 4 und 5 entspricht dabei im Hinblick auf die Füge- und/oder Prüfelemente, sowie der Ausgestaltung der ersten und zweiten Verstellachse jenem aus Fig. 1 und 2, und ergänzt dieses lediglich um die Greifaktoren 22.

In einer möglichen Ausgestaltung der vorliegenden Erfindung werden das in Fig. 1 und 2 gezeigte erste Ausführungsbeispiel und das in Fig. 4 und 5 gezeigte Ausführungsbeispiel in aufeinanderfolgenden Schritten eingesetzt.

Insbesondere kann das in Fig. 1 und 2 gezeigte erste Ausführungsbeispiel einer Füge- und/oder Prüfeinheit zur Prüfung des Bauteils und/oder zur Vormontage, insbesondere zur Vormontage von Befestigungselementen, eingesetzt werden, und das in Fig. 4 und 5 gezeigte Ausführungsbeispiel dann zur Endmontage des entsprechenden Bauteils 26, insbesondere an den Befestigungselementen.

Weiterhin kann bei einer Ausgestaltung des in Fig. 4 und 5 gezeigten Ausführungsbeispiels mit einem oder mehreren Prüfelementen ein Greifen eines Bauteils und Prüfen des Bauteils erfolgen.

Ebenso können bei dem in Fig. 4 und 5 gezeigten Ausführungsbeispiel jeweils ein oder zwei Fügeelemente und ein oder zwei Prüfelemente vorgesehen sein. Vor dem Greifen wird das Bauteils geprüft, z.B. die Spannung an den beiden Polen eines als Bauteils vorgesehenen Batteriemoduls ermittelt, und anschließend das Batteriemodul gegriffen und dann gefügt.

Da die Fügepunkte und die die Prüfpunkte darstellenden Pole des Moduls ggf. an anderen Stellen liegen, wird zwischen dem Prüfen und dem Fügen der Abstand der Fügeelemente und/oder Prüfelemente umgestellt.

Die erfindungsgemäßen Füge- und/oder Prüfeinheiten können insbesondere im Rahmen von automatisierten Hanhabungsstationen, insbesondere von automatisierten Prüf- und/oder Montagestationen zum Einsatz kommen.

Insbesondere kann die Füge- und/oder Prüfeinheit an einer Handling-Anordnung, insbesondere einem Roboterarm, angeordnet werden, und wird von dieser bewegt.

Die Steuerung der Handling-Anordung und der Füge- und/oder Prüfeinheit ist in einer möglichen Anwendung so programmiert, dass ein Bauteil gegriffen, an der Montageposition platziert und dort über die Fügeelemente montiert wird, während es noch durch den Greifer der Füge- und/oder Prüfeinheit gehalten wird.

In einer möglichen Anwendung ist die Steuerung so programmiert, dass ein Bauteil geprüft wird. Dies kann vor dem Greifen erfolgen, während das Bauteil gegriffen ist, oder nachdem es an einem Zielort angeordnet wurde.

Die beiden Anwendungen können in Kombination zum Einsatz kommen.

In einer möglichen Anwendung ist die Steuerung so programmiert, dass Montageelemente durch die Füge- und/oder Prüfeinheit montiert werden.

Dient eine erste Füge- und/oder Prüfeinheit zur Vormontage und/oder Prüfung, eine zweite Füge- und/oder Prüfeinheit zur Endmontage, sind diese bevorzugt an zwei separaten Handling-Anordnungen, insbesondere Roboterarmen, angeordnet.

Bei den Roboterarmen kann es sich insbesondere um Industrieroboter handeln, insbesondere um Industrieroboter mit mindestens sechs Drehgelenken, insbesondere um 6-Arm-Roboter.

Weist die Füge- und/oder Prüfeinheit wie in den Ausführungsbeispielen eine Kraftmesseinheit 24 auf, wird hierdurch bevorzugt durch die Steuerung die Anpresskraft, mit welcher das Bauteil in der Montageposition angepresst wird, geregelt. Insbesondere kann damit die Kraft, welche über die Anschlagelemente 20 und 21 auf das Bauteil aufgebracht wird, geregelt werden.

Insbesondere nimmt die Robotersteuerung daher eine Kraft- und Positions-Regelung vor, um das Bauteil zu montieren.

Die vorliegende Erfindung kann insbesondere im Rahmen der Montage von Autoteilen und/oder Batteriemodulen eingesetzt werden.

Insbesondere dient die Füge- und/oder Prüfeinheit zur Prüfung und/oder Montage von Batteriemodulen in einem Batterie-Pack, d.h. einer Baugruppe mit einer Mehrzahl von Batteriemodulen, insbesondere in einem Batterie-Pack eines elektrisch oder eines hybrid-elektrisch betriebenen Fahrzeugs.

In einem möglichen Ausgestaltung wird durch das Fügen das Batteriemodul an einem Gehäuse des Batterie-Packs befestigt, bspw. mit diesem verschraubt.

In einem möglichen Ausgestaltung wird durch das Prüfen eine elektrische Eigenschaft des Batteriemoduls geprüft, bspw. die Spannung des Batteriemoduls.

In einer möglichen Anwendung werden hierdurch defekte Batteriemodule erkannt und aussortiert.

Die Ermittlung der Spannung kann über zwei bis vier Prüfelemente erfolgen, welche jeweils mit einem Anschluss des Batteriemoduls in Kontakt gebracht werden.

Weiterhin kann die Füge- und/oder Prüfeinheit jeweils zwei Fügeelemente und zwei Prüfelemente umfassen. Zusätzlich kann in einer möglichen Ausgestaltung ein Greifer vorgesehen sein. Insbesondere kann die Füge- und/oder Prüfeinheit so ausgestaltet sein, wie dies in den in Fig. 1 und 2 bzw. 4 und 5 gezeigt ist, wobei jeweils zwei Fügeelemente und zwei Prüfelemente vorgesehen sind.

Die Steuerung kann so ausgestaltet sein, dass in einem ersten Schritt, insbesondere vor dem Greifen, die Spannung an den beiden Polen des Batteriemoduls ermittelt wird, anschließend das Modul gegriffen und dann gefügt. Da die Fügepunkte und die Pole des Moduls im allgemeinen an anderen Stellen liegen, wird dazwischen der Abstand der Füge- und/oder Prüfelemente umgestellt.

In einem möglichen Anwendungsfall werden die Batteriemodule über den Greifer der Füge- und/oder Prüfeinheit in eine zähflüssige Wärmeleitpaste gedrückt und in dieser Position durch die Fügeeinheit montiert. Über die Kraftmesseinheit, welche zwischen der Handling-Anordnung und der Füge- und/oder Prüfeinheit angeordnet ist, wird bevorzugt die Kraft, mit welcher das Batteriemodul in die Wärmeleitpaste gedrückt wird, überwacht und geregelt. Mit der Handling-Anordnung wird zudem die Position der Füge- und/oder Prüfeinheit und damit des Batteriemoduls überwacht und sichergestellt. Es erfolgt daher eine Kraft-Weg-Positions-Regelung.

Anschließend wird das Batteriemodul mit den Fügeelementen auf seiner Sollposition fixiert, beispielsweise verschraubt oder vernietet. Der Greifer der Füge- und/oder Prüfeinheit hat zu dieser Zeit das Batteriemodul noch gegriffen, und stellt so die Sollposition sicher. Nachdem der Fügevorgang abgeschlossen ist, öffnet sich der Greifer und die Handling-Anordnung entfernt den Greifer von dem gefügten Modul.

Anstelle von Roboterarmen sind auch andere Handling-Anordnungen zum Bewegen der Füge- und/oder Prüfeinheit denkbar, beispielsweise Linear- und/oder Flächenportale.

Durch die Verstellanordnung der Füge- und/oder Prüfeinheit ist es möglich, mit der gleichen Füge- und/oder Prüfeinheit unterschiedliche Batteriemodule zu montieren. Insbesondere können sich die Batteriemodule sowohl im Hinblick auf den Abstand der Greifpunkte, als auch im Hinblick der Fügepunkte und/oder Prüfpunkte, insbesondere der Pole, unterscheiden.

Erfolgt die Verstellung händisch, kann die Füge- und/oder Prüfeinheit für die unterschiedlichen Batteriemodule eingerichtet werden, indem die Verstellachsen händisch betätigt werden.

Bevorzugt erfolgt die Verstellung der Verstellachsen jedoch über Antriebe, und ist über die Steuerung der Handhabungsstation ansteuerbar. Bevorzugt erfolgt das Verstellen taktzeitneutral erfolgen, d.h. zwischen dem Greifen zweier aufeinanderfolgender Batteriemodule.

Neben dem beschriebenen Anwendungsfall einer Montage von Batteriemodulen zu einem Batteriepack, d.h. einer Batterieeinheit mit mehreren Batteriemodulen, sind auch andere Anwendungsfälle gegeben.

Beispielsweise kann die Füge- und/oder Prüfeinheit in gleicher Weise, wie es oben für die Montage von Batteriemodulen beschrieben wurde, zum Montieren von Batteriepacks, d.h. Einheiten mit mehreren Batteriemodulen, an einem Fahrzeug-Chassis eingesetzt werden, insbesondere an einem Fahrzeugunterboden.

Weiterhin kann die Füge- und/oder Prüfeinheit zum Montieren von Gehäuseelementen eines Batteriepacks, insbesondere eines Deckels eines Batteriepacks, eingesetzt werden.

Die Füge- und/oder Prüfeinheit kann auch in anderen Anwendungen zum Prüfen und/oder Montieren beliebiger anderer Bauteile eingesetzt werden.

Die vorliegende Erfindung erlaubt dabei eine genaue prozesssichere Prüfung und/oder Montage von Bauteilen, insbesondere von Batteriemodulen, bei geringer Taktzeit.

Einzelprozessschritte, welche von der Steuerung automatisch durchgeführt werden, sind insbesondere das genaue Positionieren, optional mit einer Kraftüberwachung, das Fixieren des Bauteils sowie das Lösen des Griffes, nachdem das Bauteil fixiert worden ist.

Im Rahmen des Einsatzes der vorliegenden Erfindung ist eine Fertigung der Losgröße 1 möglich, d.h. ein automatisches Rüsten der Füge- und/oder Prüfeinheit im Takt, z.B. während des Bauteilwechsels, wobei die Füge- und/oder Prüfeinheit durch die Verstellanordnung jeweils an das nächste zu montierende Bauteil angepasst wird.

Insbesondere erkennt eine Steuerung der Handhabungsstation das jeweils als nächstes zu montierende Bauteil, und steuert Antriebe der Versstellanordnung so an, dass die Füge- und/oder Prüfelemente und/oder Greifaktoren an die Fügepunkte und/oder Greifpunkte und/oder Prüfpunkte des Bauteils angepasst werden.

Im Ausführungsbeispiel sind die Füge- und/oder Prüfelemente nur zusammen mit den Greifaktoren über die erste Verstellachse verstellbar. Dies setzt voraus, dass bei den unterschiedlichen Bauteilen die Position der Greifpunkte zu den Fügepunkten und/oder Prüfpunkten in der ersten Richtung jeweils identisch ist, jedenfalls wenn die Prüfung und/oder das Fügen erfolgt, wenn das Bauteil gegriffen ist.

Alternativ könnten die Füge- und/oder Prüfelemente jedoch auch über eine weitere Verstellachse relativ zu den jeweiligen Greifaktoren in der ersten Richtung bewegbar sein. Bevorzugt ist eine solche weitere Verstellachsen an den Schlitten 7 der ersten Verstellachse angeordnet, sodass die Grobpositionierung in der ersten Richtung über die erste Verstellachse gemeinsam für die der Füge- und/oder Prüfelemente und die Greifaktoren erfolgt, und die Feinpositionierung über die weitere Verstellachse. An dieser weiteren Verstellachse sind dann entweder die Füge- und/oder Prüfelemente, oder die Greifaktoren angeordnet.

## Patentansprüche

1. Füge- und/oder Prüfeinheit zum Fügen und/oder Prüfen eines Bauteils mit einer Basis und einer Mehrzahl von Füge- und/oder Prüfelementen, wobei die Füge- und/oder Prüfelemente so an der Basis angeordnet sind, dass sie jeweils an einem Füge- und/oder Prüfpunkt des Bauteils eine Verbindung herstellen und/oder eine Prüfung vornehmen,
**dadurch gekennzeichnet,**
**dass** die Füge- und/oder Prüfelemente über eine Verstellanordnung, welche eine Verstellung des Abstands der Füge- und/oder Prüfelemente voneinander erlaubt, an der Basis angeordnet sind, wobei die Verstellanordnung bevorzugt eine erste und eine zweite Verstellachse umfasst, über welche der Abstand der Füge- und/oder Prüfelemente voneinander in einer ersten und einer zweiten Richtung verstellbar ist.

2. Füge- und/oder Prüfeinheit nach Anspruch 1, wobei eine Achsrichtung der ersten Verstellachse senkrecht auf einer Achsrichtung der zweiten Verstellachse steht und/oder wobei durch die erste und zweite Verstellachse der Abstand der Füge- und/oder Prüfelemente und/oder Füge- und/oder Prüfpunkte in einer Ebene verstellbar ist, welche bevorzugt senkrecht auf einer Füge- und/oder Prüfrichtung steht.

3. Füge- und/oder Prüfeinheit nach Anspruch 1 oder 2 mit mindestens einem Greifer zum Greifen des Bauteils, wobei der Greifer bevorzugt ein Halten des Bauteils erlaubt, während das Bauteil durch die Füge- und/oder Prüfelemente gefügt und/oder geprüft wird, insbesondere ein Halten in einer Soll-Position.

4. Füge- und/oder Prüfeinheit nach Anspruch 3, wobei der Greifer mindestens zwei Greifaktoren umfasst, über welche Greifelemente zum Greifen des Bauteils betätigbar sind, wobei die Greifaktoren über die Verstellanordnung an der Basis angeordnet sind, so dass der Abstand der Greifaktoren zueinander verstellbar ist.

5. Füge- und/oder Prüfeinheit zum Fügen und/oder Prüfen eines Bauteils mit einer Basis, einem Greifer und einem oder mehreren Füge- und/oder Prüfelementen, wobei der Greifer mindestens zwei Greifaktoren umfasst, über welche Greifelemente zum Greifen des Bauteils betätigbar sind, und wobei das oder die Füge- und/oder Prüfelemente so an der Basis angeordnet sind, dass sie jeweils an einem Füge- und/oder Prüfpunkt des Bauteils eine Verbindung herstellen und/oder eine Prüfung vornehmen,
**dadurch gekennzeichnet,**
**dass** die Greifaktoren und das oder die Füge- und/oder Prüfelemente über eine Verstellanordnung an der Basis angeordnet sind, über welche der Abstand der Greifaktoren und/oder des oder der Füge- und/oder Prüfelemente zueinander verstellbar ist, wobei bevorzugt die Greifaktoren über mindestens eine erste Verstellachse zueinander in mindestens einer ersten Richtung verstellbar sind und/oder das oder die Füge- und/oder Prüfelemente über mindestens eine zweite Verstellachse zu den Greifaktoren oder zueinander in mindestens eine zweite Richtung verstellbar sind.

6. Füge- und/oder Prüfeinheit nach einem der Ansprüche 3 bis 5, wobei es sich um einen mechanischen Greifer handelt und die Greifaktoren die Greifelemente entlang einer ersten Richtung bewegen, um das Bauteil zu greifen, wobei bevorzugt der Abstand zwischen den Greifaktoren durch die Verstellanordnung in der ersten Richtung verstellbar ist, um den Greifer an unterschiedlich große Bauteile anzupassen.

7. Füge- und/oder Prüfeinheit nach einem der Ansprüche 4 bis 6, wobei die Greifaktoren und das oder die Füge- und/oder Prüfelemente über mindestens eine erste Verstellachse gemeinsam verstellbar sind und/oder wobei über mindestens eine zweite Verstellachse nur die Füge- und/oder Prüfelemente verstellbar sind, wobei bevorzugt ein erster Greifaktor zusammen mit einem ersten Füge- und/oder Prüfelement oder einer Gruppe von ersten Füge- und/oder Prüfelementen an einem verstellbaren Element der ersten Verstellachse, insbesondere einem Schlitten, angeordnet ist, wobei bevorzugt an dem verstellbaren Element eine zweite Verstellachse angeordnet ist, über welche die ersten Füge- und/oder Prüfelemente zueinander und/oder zum Greifaktor verstellbar sind.

8. Füge- und/oder Prüfeinheit nach einem der vorangegangenen Ansprüche, wobei mindestens eine und bevorzugt die erste und die zweite Verstellachse so ausgestaltet ist/sind, dass sie eine symmetrische Verstellung von mindestens zwei Füge- und/oder Prüfelementen und/oder Greifaktoren relativ zur Basis vornimmt oder vornehmen.

9. Füge- und/oder Prüfeinheit nach einem der vorangegangenen Ansprüche, wobei eine erste Verstellachse zwei erste Schlitten umfasst, welche über ein erstes Antriebselement entlang einer Linearführung relativ zur Basis verfahrbar sind, wobei es sich bei dem Antriebselement bevorzugt um eine Zahnstange und/oder einen Riemenantrieb handelt,
wobei bevorzugt an jedem der beiden ersten Schlitten eine zweite Verstellachse angeordnet ist, wobei bevorzugt die zweiten Verstellachsen jeweils einen oder zwei zweite Schlitten umfassen, welcher oder welche jeweils über ein zweites Antriebselement entlang einer am ersten Schlitten angeordneten Linearführung verfahrbar ist oder sind, wobei es sich bei dem Antriebselement bevorzugt um eine Zahnstange und/oder einen Riemenantrieb handelt,
wobei die zweiten Antriebselemente bevorzugt über drittes Antriebselement gemeinsam antreibbar sind.

10. Füge- und/oder Prüfeinheit nach einem der vorangegangenen Ansprüche, mit einer oder mehreren Fixiereinheiten zur Fixierung der ersten und/oder zweiten Verstellachse, wobei es sich insbesondere um eine oder mehrere Klemm- und/oder Verriegelungseinheiten handelt.

11. Füge- und/oder Prüfeinheit nach einem der vorangegangenen Ansprüche, mit einem oder mehreren Anschlagelementen, welche eine Oberseite des Bauteils kontaktieren, um dieses in Position zu drücken, und/oder mit einer Kraftmesseinheit zum Messen einer Andrückkraft, wobei die Kraftmesseinheit bevorzugt zwischen der Basis und einem Montagebereich zur Montage der Füge- und/oder Prüfeinheit an einer Handling-Anordnung, insbesondere einem Roboterarm, angeordnet ist.

12. Füge- und/oder Prüfeinheit nach einem der vorangegangenen Ansprüche, wobei es sich bei einem oder mehreren der Füge- und/oder Prüfelemente um Fügegeräte handelt, insbesondere um Schrauber oder Nietgeräte, insbesondere mit automatischer Zuführung, und/oder um Schweißgeräte, insbesondere zum Punktschweißen, und/oder um Betätigungsaktoren zum Betätigen eines Befestigungselementes des Bauteils, und/oder wobei es sich bei einem oder mehreren der Füge- und/oder Prüfelemente um Elemente eines Prüfergerätes zum Prüfen elektrischer Eigenschaften des Bauteils handelt, insbesondere eines Spannungs-, Strom- und/oder Widerstandsgerätes, insbesondere um Kontaktelemente eines Prüfergerätes zum Prüfen elektrischer Eigenschaften des Bauteils.

13. Handhabungsstation mit einer Handling-Anordnung, insbesondere einem Roboter, und einer Füge- und/oder Prüfeinheit nach einem der vorangegangenen Ansprüche, wobei die Füge- und/oder Prüfeinheit an der Handling-Anordnung angeordnet und durch diese bewegt wird, wobei eine Steuerung der Handling-Anordnung bevorzugt eine Andrückkraft überwacht und auf einen Soll-Wert regelt und/oder den Greifer und die Füge- und/oder Prüfeinheit so ansteuert, dass ein Fügen und/oder Prüfen des Bauteils erfolgt, während dieses durch den Greifer gehalten wird.

14. Füge- und/oder Prüfeinheit nach einem der Ansprüche 1 bis 12 oder Handhabungsstation nach Anspruch 13 zur Montage und/oder Prüfung von Batterieelementen, insbesondere zur Montage von Batteriemodulen und/oder Gehäusebauteilen an Batteriepacks und/oder von Batteriepacks an einem Fahrzeug.

15. Verfahren zum Betrieb einer Füge- und/oder Prüfeinheit oder einer Handhabungsstation nach einem der vorangegangenen Ansprüche, insbesondere zur Montage von Batterieelementen, insbesondere zur Montage von Batteriemodulen und/oder Gehäusebauteilen an Batteriepacks und/oder von Batteriepacks an einem Fahrzeug,
wobei bevorzugt eine Andrückkraft überwacht und auf einen Soll-Wert geregelt wird und/oder wobei bevorzugt ein Fügen und/oder Prüfen des Bauteils erfolgt, während dieses durch den Greifer gehalten wird.
